# EUROPÄISCHE PATENTSCHRIFT

(11) **EP 0 506 616 B1**
(45) Veröffentlichungstag und Bekanntmachung des Hinweises auf die Patenterteilung: **21.01.1998**
(21) Anmeldenummer: 92810201.1
(22) Anmeldetag: 19.03.1992
(51) Int. Cl.: G03F 7/027, G03C 9/08

(54) **Photoempfindliches Gemisch auf Basis von Acrylaten**
Photosensitive acrylate mixture
Mélange photosensible à base d'acrylates

(30) Priorität: 27.03.1991 CH 936/91; 23.01.1992 CH 199/92
(43) Veröffentlichungstag der Anmeldung: 30.09.1992
(73) Patentinhaber: Ciba Specialty Chemicals Holding Inc., 4057 Basel (CH)
(72) Erfinder: Steinmann, Bettina, Dr., CH-1724 Praroman (CH); Wiesendanger, Rolf, Dr., CH-4056 Basel (CH); Schulthess, Adrian, Dr., CH-1734 Tentlingen (CH); Hunziker, Max, Dr., CH-3186 Düdingen (CH)

(56) Entgegenhaltungen:
- EP-A- 0 378 144
- EP-A- 0 425 441
- US-A- 4 789 620

## Beschreibung

Die vorliegende Erfindung betrifft ein flüssiges, photoempfindliches Gemisch, ein Verfahren zum Polymerisieren dieses Gemisches mittels aktinischer Bestrahlung, ein Verfahren zur Herstellung von dreidimensionalen Gegenständen aus den flüssigen Gemischen sowie die Verwendung der erfindungsgemässen Gemische zur Herstellung von photopolymerisierten Schichten, insbesondere von dreidimensionalen Gegenständen, die aus mehreren photopolymerisierten Schichten aufgebaut sind.

Bekanntlich können strahlungsempfindliche, flüssige Harze oder Harzgemische vielseitig angewendet werden, beispielsweise als Beschichtungsmittel, Klebstoffe oder Photoresists. Im Prinzip sollten flüssige Harze oder Harzsysteme generell auch für die Herstellung von dreidimensionalen Gegenständen nach dem im US-Patent 4,575,330 beschriebenen stereolithographischen Verfahren geeignet sein, doch erweisen sich manche Harze als zu viskos, andere wiederum sind zu wenig lichtempfindlich oder unterliegen beim Härten einem zu grossen Schrumpfungsprozess. Auch lassen die Festigkeitseigenschaften der Formkörper bzw. Gegenstände aus photogehärteten Harzen oft zu wünschen übrig.

Mittels des stereolithographischen Verfahrens kann man bekanntlich komplizierte dreidimensionale Gegenstände aus flüssigen, lichtempfindlichen Harzen herstellen. Solche Gegenstände werden schichtweise aufgebaut, wobei jede neue härtbare Harzschicht durch Vorhärtung mittels UV/VIS-Licht mit der vorhergehenden vorgehärteten Schicht fest verbunden wird. Der Gesamtaufbau des dreidimensionalen Gegenstandes lässt sich bekanntlich nach einem computergesteuerten Prozess bewerkstelligen.

In den letzten Jahren hat es nicht an Anstrengungen gefehlt, Harzsysteme zu entwickeln, welche für das stereolithographische Verfahren einsetzbar sind. H. Kodama offenbart in Rev. Sci. Instrum. 52 (11) 1170-1173 (1981) unter dem Handelsnamen "Tevista" ein flüssiges, photohärtbares Harzgemisch, bestehend aus einem ungesättigten Polyester, Acrylsäureester, Styrol, einem Polymerisationsinitiator und einem Sensibilisator. Dieses Harzsystem ist für das stereolithographische Verfahren mit dem Nachteil behaftet, dass die Photoempfindlichkeit ungenügend ist und die sogenannte Grünfestigkeit (green strength) der mit Laserstrahlen vorgehärteten Gegenstände relativ niedrig ist.

Im US-Patent 4,575,330 wird das stereolithographische Verfahren näher beschrieben, wobei als flüssiges Harz ein modifiziertes Acrylat eingesetzt wird, das in der Beschreibung als "Potting Compound 363" bezeichnet wird. Solche Harzgemische werden im US-Patent 4,100,141 offenbart. Auch sie haben den Nachteil, dass sie ungenügend photoempfindlich sind und lange Zeiten für die Herstellung von dreidimensionalen Gegenständen nach dem stereolithographischen Verfahren benötigen.

Es ist daher verständlich, dass an Harze, die in stereolithographischen Verfahren eingesetzt werden sollen, hohe Anforderungen gestellt werden. Beispielsweise müssen sie hinsichtlich ihrer apparativen Verarbeitung eine geeignete Viskosität aufweisen. Die Photoempfindlichkeit des Harzsystems soll so beschaffen sein, dass das Verhältnis von aufgewendeter Strahlungsenergie und erzielter Eindringtiefe in das flüssige photoempfindliche Harzgemisch, wobei die betreffenden Teile sich verfestigen, im vertretbaren Rahmen liegt Das heisst, bei einem für das stereolithographische Verfahren geeigneten Harz oder Harzgemisch soll mit wenig Strahlungsenergie eine möglichst hohe Härtungstiefe bei gleichzeitig hohem Polymerisationsgrad und guter Grünfestigkeit erreicht werden.

Beim Verfahren der aufeinanderfolgenden Polymerisation von dünnen Schichten, wie es im stereolithographischen Verfahren angewendet wird, ist gewöhnlich keine dieser Schichten völlig ausgehärtet. Der nicht völlig gehärtete Gegenstand wird als Grünling bezeichnet, und der Elastizitätsmodul und die Zugfestigkeit dieses Grünlings bezeichnet man auch als Grünfestigkeit Normalerweise wird der Grünling dann mit UV/VIS-Licht gehärtet, beispielsweise mittels einer Quecksilber- oder Xenonbogenlampe. Die Grünfestigkeit eines Werkstückes stellt daher einen wichtigen Parameter dar, da Gegenstände mit einer geringen Grünfestigkeit unter ihrem eigenen Gewicht sich deformieren können oder sie können bei der Aushärtung sich durchbiegen oder absacken.

Es wurde nun gefunden, dass ein flüssiges, aus mehreren voneinander verschiedenen (Meth)acrylaten bestehendes Harzgemisch, das ausserdem ein hydroxygruppenhaltiges aliphatisches oder cycloaliphatisches Di(meth)acrylat enthält, für das stereolithographische Verfahren eingesetzt werden kann und bei der Vorhärtung mittels Laserstrahlen Grünlinge ergibt, welche sich durch eine hohe Grünfestigkeit auszeichnen. Die durch Aushärtung der Grünlinge erhaltenen Gegenstände weisen eine hohe Flexibilität auf und zeichnen sich ausserdem durch einen hohen Weiterreisswiderstand aus.

Gegenstand vorliegender Erfindung ist somit ein flüssiges, photoempfindliches Gemisch, enthaltend
(1) 40 bis 80 Gew.-% eines Urethan(meth)acrylates mit einer Funktionalität von 2 bis 4 und einem Molekulargewicht (MG) von 500 bis 10000,
(2) 5 bis 40 Gew.-% eines hydroxygruppenhaltigen aliphatischen oder cycloaliphatischen Di(meth)acrylates,
(3) 0 bis 40 Gew.-% eines Mono(meth)acrylates oder einer Mono-N-vinylverbindung mit einem MG von höchstens 500,
(4) 0,1 bis 10 Gew.-% eines Photoinitiators,
(5) 0 bis 30 Gew.-% eines von (2) verschiedenen aliphatischen oder cycloaliphatischen Di(meth)acrylates, eines aliphatischen Tri(meth)acrylates oder eines aromatischen Di- oder Tri(meth)acrylates und
(6) 0 bis 5 Gew.-% üblicher Additive,
wobei der Anteil der Komponenten (1) bis (6) zusammen 100 Gew.-% beträgt.

Vorzugsweise enthält das erfindungsgemässe Gemisch
(1) 40 bis 80 Gew.-% eines Urethan(meth)acrylates mit einer Funktionalität von 2 bis 4 und einem Molekulargewicht (MG) von 500 bis 10000,
(2) 5 bis 40 Gew.-% eines hydroxygruppenhaltigen aliphatischen oder cycloaliphatischen Di(meth)acrylates,
(3) 5 bis 40 Gew.-% eines Mono(meth)acrylates oder einer Mono-N-vinylverbindung mit einem MG von höchstens 500,
(4) 0,1 bis 10 Gew.-% eines Photoinitiators,
(5) 0 bis 30 Gew.-% eines von (2) verschiedenen aliphatischen oder cycloaliphatischen Di(meth)acrylates, eines aliphatischen Tri(meth)acrylates oder eines aromatischen Dioder Tri(meth)acrylates und
(6) 0 bis 5 Gew.-% üblicher Additive.

Insbesondere enthält das erfindungsgemässe Gemisch
(1) 50 bis 70 Gew.-% eines Urethan(meth)acrylates mit einer Funktionalität von 2 bis 4 und einem MG von 1000 bis 10000,
(2) 10 bis 30 Gew.-% eines hydroxygruppenhaltigen aliphatischen Di(meth)acrylates,
(3) 0 bis 30 Gew.-% eines Mono(meth)acrylates oder einer Mono-N-vinylverbindung mit einem MG von höchstens 500,
(4) 0,5 bis 7 Gew.-% eines Photoinitiators,
(5) 0 bis 20 Gew.-% eines von (2) verschiedenen aliphatischen oder cycloaliphatischen Di(meth)acrylates, eines aliphatischen Tri(meth)acrylates oder eines aromatischen Di- oder Tri(meth)acrylates und
(6) 0 bis 3 Gew.-% eines Additivs.

Bei der besonders bevorzugten Ausführungsform enthält die Mischungskomponente (3) vorzugsweise 10 bis 30 Gew.-% eines Mono(meth)acrylates oder einer Mono-N-vinylverbindung mit einem MG von höchstens 500.

Die in den erfindungsgemässen Gemischen als Komponente (1) verwendeten Urethanacrylate sind dem Fachmann bekannt und können in bekannter Weise hergestellt werden, indem man beispielsweise ein hydroxylterminiertes Polyurethan mit Acrylsäure oder Methacrylsäure zu dem entsprechenden Urethanacrylat umsetzt, oder indem man ein isocyanatterminiertes Präpolymer mit Hydroxyalkylacrylaten oder -methacrylaten zum Urethanacrylat umsetzt. Entsprechende Verfahren werden beispielsweise in den publizierten EP-Patentanmeldungen 114982 und 133908 offenbart. Das Molekulargewicht solcher Acrylate liegt im allgemeinen im Bereich von 400 bis 10000, vorzugsweise zwischen 500 bis 7000.

Urethanacrylate sind auch im Handel erhältlich und werden beispielsweise unter der Bezeichnung EBECRYL® von der Firma UCB, unter der Bezeichnung Uvithane® von der Firma Morton Thiokol oder unter den Produktebezeichnungen SR 9504, SR 9600, SR 9610, SR 9620, SR 9630, SR 9640 und SR 9650 von der Firma SARTOMER Company angeboten.

Bevorzugt werden als Urethanacrylate solche eingesetzt, die ein MG von 500-7000 aufweisen und die insbesondere aus aliphatischen Edukten hergestellt worden sind.

Als Verbindungen der Komponente (2) eignen sich beispielsweise Umsetzungsprodukte aus aliphatischen Epoxidharzen, wie Alkandioldiglycidylether, beispielsweise Butan-1,4-dioldiglycidylether, Polyethylenglykol- oder Polybutylenglykoldiglycidylether, oder cycloaliphatischen Epoxidharzen, wie cycloaliphatische Dicarbonsäurediglycidylester, beispielsweise Hexahydrophthalsäurediglycidylester, oder hydrierte Bisphenoldiglycidylether, beispielsweise hydrierter Bisphenol A-diglycidylether, oder Epoxidharze mit direkt am cycloaliphatischen Ring gebundener Epoxidgruppe, beispielsweise Bis(3,4-epoxycyclohexylmethyl)-adipat, wobei die beispielsweise genannten Verbindungen mit (Meth)acrylsäure zu Umsetzungsprodukten mit folgenden Formeln führen 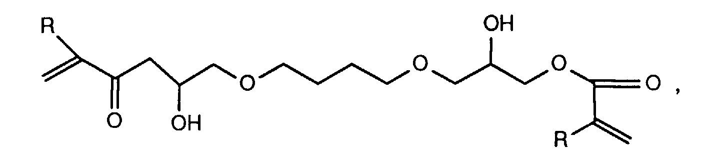 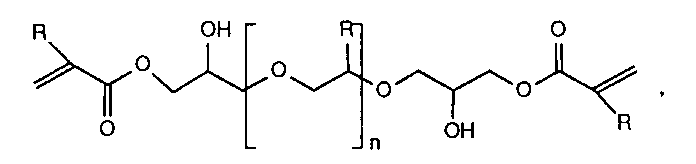 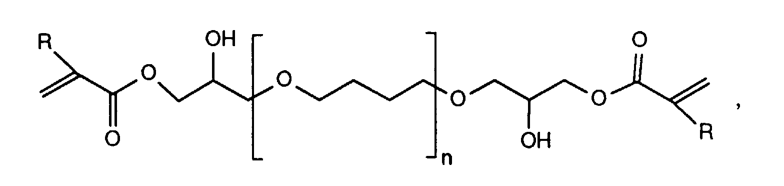 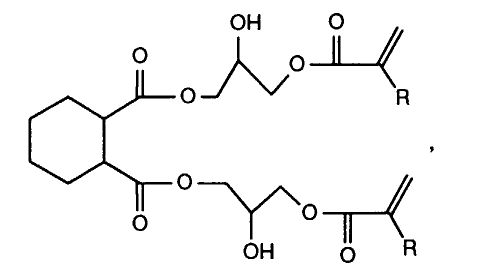 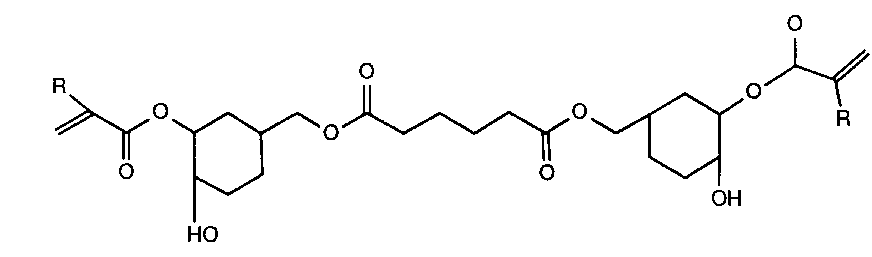 oder 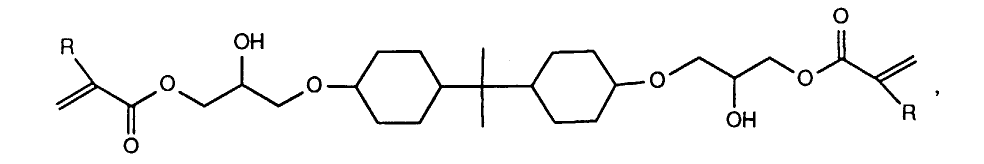 worin R für ein Wasserstoffatom oder Methyl und n für eine Zahl grösser als 1 stehen, ferner Umsetzungsprodukte aus epoxidierter Fettsäure mit (Meth)acrylsäure oder mit Caprolacton modifizierte Umsetzungsprodukte aus aliphatischen oder cycloaliphatischen Epoxidharzen, wie Butan-1,4-dioldiglycidylether, mit (Meth)acrylsäure, wobei ein Produkt der Formel 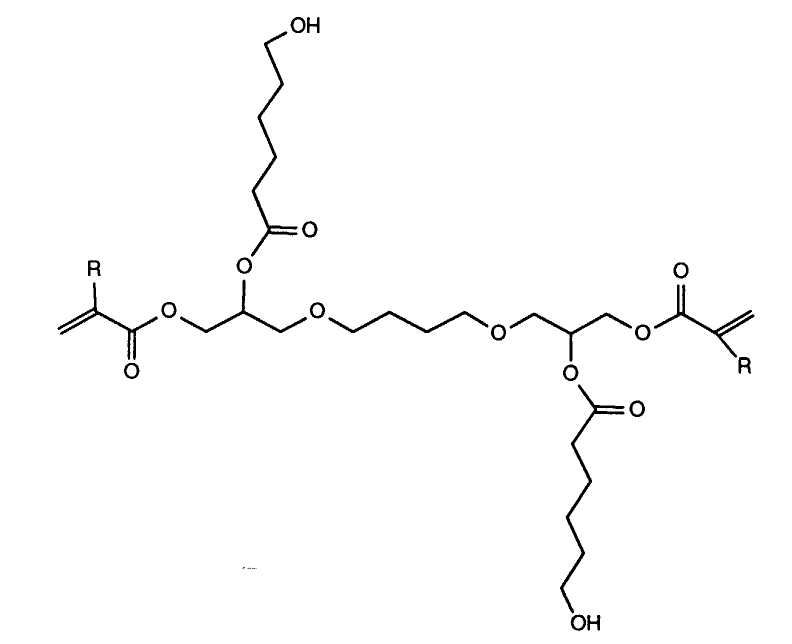 erhalten wird, worin R für ein Wasserstoffatom oder Methyl steht. Die oben angegebenen Umsetzungsprodukte aus aliphatischen oder cycloaliphatischen Epoxidharzen und (Meth)acrylsäure sind bekannt, beispielsweise aus der JP-Anmeldung Kokai 50-059487 oder aus Org. Coat. Plast. Chem. 40, Seiten 104- 109, 1979, wo auch Herstellungsverfahren beschrieben werden.

Das mit Caprolacton modifizierte Umsetzungsprodukt aus aliphatischen oder cycloaliphatischen Epoxidharzen und (Meth)acrylsäure ist ebenfalls bekannt und kann hergestellt werden, indem man beispielsweise 1 Mol eines Umsetzungsproduktes aus dem aliphatischen oder cycloaliphatischen Epoxidharz und (Meth)acrylsäure mit 2 Mol Caprolacton in einem organischen Lösungsmittel in der Hitze und gegebenenfalls in Gegenwart eines Katalysators umsetzt.

Als weitere aliphatische oder cycloaliphatische Epoxidharze, die zur Herstellung der oben genannten Umsetzungsprodukte eingesetzt werden können, seien zum Beispiel genannt: Die Diglycidyl- und Di(β-methylglycidyl)-ester von aliphatischen Dicarbonsäuren, wie Oxalsäure, Bernsteinsäure, Glutarsäure, Pimelinsäure, Korksäure, Azelainsäure, Sebacinsäure oder dimerisierter Linolsäure, die Diglycidylester von cycloaliphatischen Dicarbonsäuren, wie Tetrahydrophthalsäure, 4-Methyltetrahydrophthalsäure oder 4-Methylhexahydrophthalsäure, die Diglycidylether von höheren aliphatischen Alkoholen, wie Pentan-1,5-diol, Hexan-1,6-diol oder Octan-1,8-diol, die Diglycidylether aus cycloaliphatischen Diolen, wie Resorcit, Chinit, Bis-(4-hydroxycyclohexyl)-methan, 2,2-Bis-(4-hydroxycyclohexyl)-propan und 1,1-Bis-(hydroxymethyl)-3-cyclohexen.

Vorzugsweise enthalten die erfindungsgemässen Gemische als hydroxygruppenhaltiges aliphatisches Diacrylat (2) ein Umsetzungsprodukt aus Butan-1,4-dioldiglycidylether und Acrylsäure.

Vorzugsweise enthalten die erfindungsgemässen Gemische als Komponente (2) ein hydroxygruppenhaltiges cycloaliphatisches Di(meth)acrylat, insbesondere ein Umsetzungsprodukt aus Hexahydrophthalsäurediglycidylester oder Bis-(3,4-epoxycyclohexylmethyl)-adipat und (Meth)acrylsäure.

In den erfindungsgemässen Gemischen können als Komponente (3) beispielsweise folgende Verbindungen enthalten sein: Allylacrylat, Allylmethacrylat, Methyl-, Ethyl-, n-Propyl-, n-Butyl-, Isobutyl-, n-Hexyl-, 2-Ethylhexyl-, n-Octyl-, n-Decyl- und n-Dodecylacrylat und -methacrylat, 2-Hydroxyethyl-, 2- und 3-Hydroxypropylacrylat und -methacrylat, 2-Methoxyethyl-, 2-Ethoxyethyl- und 2- oder 3-Ethoxypropylacrylat, Tetrahydrofurfurylmethacrylat, 2-(2-Ethoxyethoxy)ethylacrylat, Cyclohexylmethacrylat, 2-Phenoxyethylacrylat, Glycidylacrylat und Isodecylacrylat sowie als Mono-N-vinylverbindung N-Vinylpyrrolidon oder N-Vinylcaprolactam. Solche Produkte sind ebenfalls bekannt und zum Teil im Handel erhältlich, zum Beispiel von der Firma SARTOMER.

Vorzugsweise weisen die Verbindungen der Komponente (3) ein MG von 50-300 auf.

Ferner enthalten die erfindungsgemässen Gemische als Komponente (3) vorzugsweise eine Mono-N-vinylverbindung, insbesondere N-Vinylpyrrolidon.

In den erfindungsgemässen Gemischen können alle Typen von Photoinitiatoren als Komponente (4) eingesetzt werden, welche bei der entsprechenden Bestrahlung freie Radikale bilden. Typische Verbindungen bekannter Photoinitiatoren sind Benzoine, wie Benzoin, Benzoinether, wie Benzoinmethylether, Benzoinethylether und Benzoinisopropylether, Benzoinphenylether und Benzoinacetat, Acetophenone, wie Acetophenon, 2,2-Dimethoxyacetophenon, und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert.-Butylanthrachinon, 1-Chloranthrachinon und 2-Amylanthrachinon, Triphenylphosphin, Benzoylphosphinoxide, wie beispielsweise 2,4,6-Trimethylbenzoyldiphenylphosphinoxid (Luzirin TPO), Benzophenone, wie Benzophenon und 4,4'-Bis-(N,N'-dimethylamino)-benzophenon, Thioxanthone und Xanthone, Acridinderivate, Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenylketon, Phenyl-(1-hydroxyisopropyl)-keton und 4-Isopropylphenyl-(1-hydroxyisopropyl)-keton, welche alle bekannte Verbindungen darstellen.

Besonders geeignete Photoinitiatoren, welche gewöhnlich in Kombination mit einem HeCd-Laser als Strahlenquelle verwendet werden, sind Acetophenone, wie 2,2-Dialkoxybenzophenone und 1-Hydroxyphenylketone, beispielsweise 1-Hydroxycyclohexylphenylketon oder (2-Hydroxyisopropyl)-phenylketon (= 2-Hydroxy-2,2-dimethylacetophenon).

Eine andere Klasse von Photoinitiatoren (4), die gewöhnlich bei Verwendung von Argonion-Lasern eingesetzt wird, sind die Benzilketale, wie beispielsweise Benzildimethylketal. Insbesondere verwendet man als Photoinitiator ein α-Hydroxyphenylketon, Benzildimethylketal, 2,4,6-Trimethylbenzoyldiphenylphosphinoxid oder Mischungen dieser Initiatoren.

Eine weitere Klasse von geeigneten Photoinitiatoren (4) stellen die ionischen Farbstoff-Gegenionverbindungen (ionic dye-counter ion compound) dar, welche in der Lage sind, aktinische Strahlen zu absorbieren und freie Radikale zu erzeugen, die die Polymerisation der Acrylate (1) bis (3) und gegebenenfalls (5) initiieren. Die erfindungsgemässen Gemische, welche ionische Farbstoff-Gegenionverbindungen enthalten, können auf diese Weise mit sichtbarem Licht im einstellbaren Wellenlängenbereich von 400-700 nm variabler gehärtet werden. Ionische Farbstoff-Gegenionverbindungen und deren Wirkungsweise sind bekannt, beispielsweise aus der EP-A-O 223 587 und den US-Patenten 4,751,102; 4,772,530 und 4,772,541. Als Beispiele für geeignete ionische Farbstoff-Gegenionverbindungen seien genannt die anionischen Farbstoff-Jodoniumionkomplexe, die anionischen Farbstoff-Pyrylliumionkomplexe und insbesondere die kationischen Farbstoff-Boratanionverbindungen der folgenden Formel 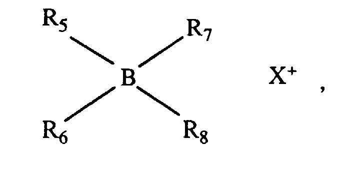 worin X⁺ für einen kationischen Farbstoff steht und R₅, R₆, R₇ und R₈ unabhängig voneinander je ein Alkyl, Aryl, Alkaryl, Allyl, Aralkyl, Alkenyl, Alkinyl, eine alicyclische oder gesättigte oder ungesättigte heterocyclische Gruppe bedeuten.

Die Photoinitiatoren werden bekanntlich in wirksamen Mengen zugesetzt, das heisst, in Mengen von etwa 0,1 bis etwa 10 Gewichtsprozent, bezogen auf die Gesamtmenge des Gemisches. Wenn die erfindungsgemässen Gemische für stereolithographische Verfahren verwendet werden, wobei normalerweise Laserstrahlen eingesetzt werden, ist es wesentlich, dass die Absorptionsfähigkeit der Gemische durch Typ und Konzentration des Photoinitiators so abgestimmt wird, dass die Härtungstiefe bei normaler Lasergeschwindigkeit ungefähr 0,1 bis 2,5 mm beträgt.

Die erfindungsgemässen Gemische können auch verschiedene Photoinitiatoren enthalten, welche gegenüber Strahlen von Emissionslinien unterschiedlicher Wellenlängen verschieden strahlungsempfindlich sind. Man erreicht dadurch beispielsweise eine bessere Ausnützung einer UV/VIS-Lichtquelle, welche Emissionslinien unterschiedlicher Wellenlänge ausstrahlt. Vorteilhaft ist es dabei, wenn die verschiedenen Photoinitiatoren so ausgewählt und in einer solchen Konzentration eingesetzt werden, dass bei den verwendeten Emissionslinien eine gleiche optische Absorption erzeugt wird.

Vorzugsweise enthalten die erfindungsgemässen Gemische als Photoinitiator (4) ein 1-Hydroxyphenylketon, insbesondere 1-Hydroxycyclohexylphenylketon.

Die erfindungsgemässen Gemische können gegebenenfalls noch weitere, von der Komponente (2) verschiedene Acrylate als Komponente (5) enthalten.

Als von (2) verschiedene aliphatische oder cycloaliphatische Di(meth)acrylate für die Komonente (5) eignen sich beispielsweise die Diacrylat- und Dimethacrylatester von aliphatischen oder cycloaliphatischen Diolen, wie 1,3-Butylenglykol, 1,4-Butandiol, Neopentlylglykol, 1,6-Hexandiol, Diethylenglykol, Triethylenglykol, Tetraethylenglykol, Polyethylenglykol-400, Polyethylenglykol-600, Tripropylenglykol, ethoxyliertes oder propoxyliertes Neopentylglykol, 1,4-Dimethylcyclohexan, 2,2-Bis-(4-hydroxycyclohexyl)-propan oder Bis-(4-hydroxycyclohexyl)-methan.

Als aliphatische Tri(meth)acrylate für die Komponente (5) eignen sich beispielsweise die hydroxygruppenfreien Triacrylat- und Trimethacrylatester von Hexan-2,4,6-triol, Glycerin oder 1,1,1-Trimethylolpropan, ethoxyliertes oder propoxyliertes Glycerin oder 1,1,1-Trimethylolpropan und die hydroxygruppenhaltigen Tri(meth)acrylate, die durch Umsetzung von Triepoxidverbindungen, wie beispielsweise die Triglycidylether von den genannten Triolen, mit (Meth)acrylsäure erhalten werden.

Als aromatische Di- und Tri(meth)acrylate der Komponente (5) eignen sich beispielsweise die Umsetzungsprodukte aus Di- oder Triglycidylethern zwei- oder dreiwertiger Phenole, wie Resorcin. Hydrochinon, Bis-(4-hydroxyphenyl)-methan, 4,4'-Dihydroxydiphenyl, Bis-(4-hydroxyphenyl)-sulfon, 1,1,2,2-Tetrakis-(4-hydroxyphenyl)-ethan, 2,2-Bis(4-hydroxyphenyl)-propan ethoxyliertes oder propoxyliertes 2,2-Bis-(4-hydroxyphenyl)-propan und 2,2-Bis-(3,5-dibrom-4-hydroxyphenyl)-propan und drei Hydroxylgruppen aufweisende Phenol- oder Kresolnovolake mit (Meth)-acrylsäure.

Die als Komponente (5) eingesetzten Acrylate stellen ebenfalls bekannte Verbindungen dar.

Vorzugsweise enthalten die erfindungsgemässen, photoempfindlichen Gemische als Komponente (5) ein Umsetzungsprodukt aus einem Bisphenoldiglycidylether und Acrylsäure, insbesondere aus einem Bisphenol A-diglycidylether und Acrylsäure.

Falls erwünscht können den erfindungsgemässen Gemischen die üblichen Additive zugesetzt werden, beispielsweise Stabilisatoren, wie UV-Stabilisatoren, Polymerisationsinhibitoren, Trennmittel, Benetzungsmittel, Verlaufsmittel, Sensibilisatoren, Antiabsetzmittel, oberflächenaktive Mittel, Farbstoffe, Pigmente oder Füllstoffe.

Die erfindungsgemässen Gemische können in bekannter Weise hergestellt werden, beispielsweise durch Vormischen einzelner Komponenten und anschliessendes Vermischen dieser Vormischungen oder durch Vermischen aller Komponenten mittels üblicher Vorrichtungen, wie Rührbehälter, in Abwesenheit von Licht und gegebenenfalls bei leicht erhöhter Temperatur.

Die erfindungsgemässen, photoempfindlichen Gemische können durch Bestrahlen mit aktinischem Licht, beispielsweise mittels Elektronen-, Röntgenstrahlen, UV- oder VIS-Licht, das heisst, mit Strahlen im Wellenlängenbereich von 280-650 nm, polymerisiert werden. Besonders geeignet sind Laserstrahlen von HeCd, Argon oder Stickstoff sowie Metalldampf und NdYAG-Laser mit vervielfachter Frequenz. Es ist dem Fachmann bekannt, dass für jede gewählte Lichtquelle der geeignete Photoinitiator ausgewählt und gegebenenfalls sensibilisiert werden muss. Man hat erkannt, dass die Eindringtiefe der Strahlen in die zu polymerisierende Zusammensetzung und die Arbeitsgeschwindigkeit in direktem Zusammenhang mit dem Absorptionskoeffizienten und der Konzentration des Photoinitiators stehen. In der Stereolithographie werden vorzugsweise solche Photoinitiatoren eingesetzt, welche die höchste Anzahl von entstehenden freien Radikalen bewirken und die grösste Strahlungseindringtiefe in die zu polymerisierenden Zusammensetzungen ermöglichen.

Gegenstand der Erfindung ist somit auch ein Verfahren zum Polymerisieren der erfindungsgemässen Gemische, indem man diese mit aktinischem Licht bestrahlt.

Die erfindungsgemässen Gemische sind Flüssigkeiten mit einer Viskosität von etwa 150 bis etwa 10000 mPa·s bei 30°C, vorzugsweise von 300 bis 10000 mPa·s, insbesondere von 500 bis 5000 mPa·s und ganz besonderes bevorzugt von 500 bis 2500m Pa·s. Die erfindungsgemässen Gemische weisen bei hoher Lichtempfindlichkeit überraschenderweise einen niedrigen Schrumpfungsfaktor (curl factor) und eine hohe Formfestigkeit nach der Vorhärtung mittels Laserstrahlen (green strength) auf, was besonders bei stereolithographischen Verfahren wichtig ist. Nach der vollständigen Aushärtung weisen die aus den erfindungsgemässen Gemischen hergestellten Formkörper eine hohe Festigkeit, bei ausreichender Elastizität aus, sie sind also hartelastisch und haben einen hohen Weiterreisswiderstand.

Ein weiterer Erfindungsgegenstand ist auch ein Verfahren zur Herstellung von dreidimensionalen Gegenständen aus den flüssigen, erfindungsgemässen Gemischen mittels lithographischen Verfahren, insbesondere stereolithographischen Verfahren, wobei die Oberfläche einer Schicht aus dem erfindungsgemässen, flüssigen Gemisch ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht aus den erfindungsgemässen Gemischen auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

Bei diesem Verfahren wird als Strahlungsquelle vorzugsweise ein Laserstrahl verwendet, der vorzugsweise computergesteuert ist.

Werden die erfindungsgemässen Gemische als Beschichtungsmittel eingesetzt, so erhält man klare und harte Beschichtungen auf Holz, Papier, Metall, Keramik oder anderen Oberflächen. Die Beschichtungsdicke kann dabei sehr variieren und etwa von 1 µm bis etwa 1 mm betragen. Aus den erfindungsgemässen Gemischen können Reliefbilder für gedruckte Schaltungen oder Druckplatten direkt durch Bestrahlen der Gemische hergestellt werden, beispielsweise mittels eines computergesteuerten Laserstrahls geeigneter Wellenlänge oder unter Anwendung einer Photomaske und einer entsprechenden Lichtquelle.

Vorzugsweise verwendet man die erfindungsgemässen Gemische zur Herstellung von photopolymerisierten Schichten, insbesondere in Form von dreidimensionalen Gegenständen, die aus mehreren aneinander haftenden, verfestigten Schichten aufgebaut sind.

In den Beispielen werden folgende Urethanacrylate und hydroxygruppenhaltige Di(meth)acrylate eingesetzt:

Uvithane® 892: Urethanacrylat der Firma Morton Thiokol Inc., Doppelbindungsäquivalent = 1800, Viskosität=410 Pa·s bei 49°C.

SR-9504: Urethanacrylat der Firma Sartomer, MG=1700, Viskosität von etwa 167 Pa·s bei 25°C.

Diacrylat I: Umsetzungsprodukt aus einem Bisphenol A-diglycidylether und Acrylsäure, das im Handel unter der Bezeichnung Novacure® 3700 erhältlich ist.

Diacrylat II: Umsetzungsprodukt aus Butandioldiglycidylether und Acrylsäure, das im Handel unter der Bezeichnung Laromer® LR 8765 erhältlich ist.

Diacrylat III: Umsetzungsprodukt aus Hexahydrophthalsäurediglycidylester und Methacrylsäure mit einem Doppelbindungsgehalt von 4,06 Äquivalenten/kg, das erhalten wird, indem man 100 g Hexahydrophthalsäurediglycidylester mit einem Epoxidgehalt von 7,0 Äquivalenten/kg mit 66,2 g (0,77 Mol) Methacrylsäure und 1 Gew.-% Tetraammoniumbromid als Katalysator in Toluol als Lösungsmittel umsetzt.

Diacrylat IV: Umsetzungsprodukt aus Sorbitdiglycidylether und Acrylsäure mit einem Doppelbindungsgehalt von 3,3 Äquivalenten/kg, das erhalten wird, indem man 100 Sorbitdiglycidylether mit einem Epoxidgehalt von 4,90 Äquivalenten/kg mit 38,84 g (0,54 Mol) Acrylsäure nach dem in der JP-Anmeldung Kokai 63-132 916 beschriebenen Verfahren umsetzt.

Diacrylat V: Umsetzungsprodukt aus Polypropylenglykoldiglycidylether und Acrylsäure mit einem Doppelbindungsgehalt von 2,27 Äquivalenten/kg, das erhalten wird, indem man 100 g Polypropylenglykoldiglycidylether mit einem Epoxidgehalt von 2,71 Äquivalenten/kg mit 21,4 g (0,3 Mol) Acrylsäure nach dem in der JP-Anmeldung Kokai 63- 132 916 beschriebenen Verfahren umsetzt.

Diacrylat VI: Umsetzungsprodukt aus Bis-(3,4-epoxycyclohexylmethyl)-adipat und Acrylsäure mit einem Doppelbindungsgehalt von 3, 18 Äuivalenten/kg, das erhalten wird, indem man 100 g Bis-(3,4-epoxycyclohexylmethyl)-adipat mit einem Epoxidgehalt von 5,0 Äquivalenten/kg mit 39,6 g (0,55 Mol) Acrylsäure nach dem in der JP-Anmeldung Kokai 63-132 916 beschriebenen Verfahren umsetzt.

Diacrylat VII: Umsetzungsprodukt aus Hexahydrophthalsäurediglycidylester und Äcrylsäure mit einem Doppelbindungsgehalt von 4,06 Äquivalenten/kg, das erhalten wird, indem man 100 g Hexahydrophthalsäurediglycidylester mit einem Epoxidgehalt von 7,0 Äquivalenten/kg mit 55,4 g (0,77 Mol) Acrylsäure und 1 Gew.-% Tetraethylammoniumbromid als Katalysator umsetzt.

Diacrylat VIII: Umsetzungsprodukt aus Sorbitdiglycidylether und Methacrylsäure mit einem Doppelbindungsgehalt von 2,9 Äquivalenten/kg, das erhalten wird, indem man 100 g Sorbitdiglycidylether mit einem Epoxidgehalt von 4,90 Äquivalenten/kg mit 46,4 g (0,54 Mol) Methacrylsäure und 1 Gew.-% Tetraethylammoniumbromid als Katalysator umsetzt.

Beispiel 1: 60 g Urethanacrylat SR 9504 werden mit 20 g N-Vinylpyrrolidon, 5 g 1-Hydroxycyclohexylphenylketon und 15 g Hexahydrophthalsäurediglycididylesterdimethacrylat bei 40°C vermischt. Die resultierende homogene flüssige Mischung weist eine Viskosität von 1390 mPa·s bei 35°C auf. Ein aus diesem Gemisch mit Hilfe eines He-Cd-Lasers (40 mJ/cm²) gehärteter Formkörper weist einen Elastizitätsmodul (E-Modul gemäss DIN 53371; green strength) von 3 N/mm², eine Zugfestigkeit σ max (DIN 53455) von 1 N/mm² und eine Bruchdehnung ε (DIN 35 455) von 32 % auf.

Nach der Aushärtung des Grünlings während 30 min. unter UV/VIS-Licht beträgt der E-Modul 479 N/mm², die Zugfestigkeit 28 N/mm² und die Bruchdehnung 37 %. Zur Messung der Shore D-Härte und des Weiterreisswiderstandes werden mit dem flüssigen Material 2 mm dicke Platten gegossen, und 60 min. unter UV/VIS-Licht ausgehärtet Die Shore-D-Härte des so ausgehärteten Gemisches beträgt 72, der Weiterreisswiderstand (DIN 53356A) 3,1 N/mm².

Beispiel 2-7: Es werden wie in Beispiel 1 Formulierungen aus den in Tabelle 1 und 2 angegebenen Komponenten hergestellt und zu dreidimensionalen Formkörpern bzw. zu Platten unter den in Beispiel 1 angegebenen Bedingungen verarbeitet. Die Eigenschaften der erhaltenen Formkörper sind ebenfalls in Tabelle 1 und 2 angegeben.

**Tabelle 1**

| Beispiel | 2 | 3 | 4 |
|---|---|---|---|
| Uvithane 892 [g] | 53,95 | 59,425 | 60,0 |
| N-Vinylpyrrolidon [g] | 17,575 | 24,265 | 20,0 |
| Diacrylat I [g] | 6,350 | | |
| Diacrylat II [g] | 17,123 | 11,309 | |
| Diacrylat III [g] | | | 15,0 |
| 1-Hydroxycyclohexylphenylketon [g] | 5,0 | 5,0 | 5,0 |
| η (35°C) [mPa·s] | 2990 | 1970 | 2940 |
| *E-Modul [N/mm²] | 12 | 2,4 | 1,4 |
| * σₘₐₓ [N/mm²] | 3,3 | 1 | 1,2 |
| *ε [%] | 44 | 41 | 68 |
| ** E-Modul [N/mm²] | 60 | 25 | 136 |
| ** σₘₐₓ [N/mm²] | 14 | 15 | 27 |
| ** ε[%] | 64 | 96 | 90 |
| **Weiterreisswiderstand [N/mm] | 5 | 8 | 10,0 |
| ** Shore D-Härte | 55 | 47 | 53 |

| | | | |
|---|---|---|---|
| * Werte nach Laserhärtung (40 mJ/cm²) | | | |
| ** Werte nach vollständiger Aushärtung | | | |

**Tabelle 2**

| Beispiel | 5 | 6 | 7 |
|---|---|---|---|
| SR 9504 [g] | 60 | 60 | 60 |
| N-Vinylpyrrolidon [g] | 20 | 20 | 20 |
| 1-Hydroxycyclohexylphenylketon [g] | 5 | 5 | 5 |
| Diacrylat IV [g] | | | |
| Diacrylat V [g] | 15 | | |
| Diacrylat II [g] | | | |
| Diacrylat III[g] | | 15 | |
| Diacrylat VI [g] | | | 15 |
| η (35°C) [mPa·s] | 1220 | 1550 | 1670 |
| *E-Modul [N/mm²] | 9 | 72 | 72 |
| *σₘₐₓ [N/mm²] | 2 | 6 | 7 |
| *ε[%] | 22 | 29 | 31 |
| ** E-Modul[N/mm²] | 118 | 458 | 425 |
| ** σₘₐₓ [N/mm²] | 14 | 29 | 26 |
| ** ε[%] | 39 | 36 | 38 |
| Weiterreisswiderstand (DIN-53356A) [N/mm] | 1,7 | 4,2 | 3,1 |
| Shore D-Härte | 47 | 68 | 69 |

| | | | |
|---|---|---|---|
| * Werte nach Laserhärtung (40 mJ/cm²) | | | |
| ** Werte nach vollständiger Aushärtung | | | |

Beispiele 8 und 9: Es werden wie in Beispiel 1 Formulierungen aus der in Tabelle 3 angegebenen Komponenten hergestellt und zu dreidimensionalen Formkörpern bzw. zu Platten unter den in Beispiel 1 angegebenen Bedingungen verarbeitet. Die Eigenschaften der erhaltenen Formkörper sind ebenfalls in Tabelle 3 angegeben.

**Tabelle 3**

| Beispiel | 8 | 9 |
|---|---|---|
| Uvithane 892 | 60 | 60 |
| N-Vinylpyrrolidon | 20 | 20 |
| Diacrylat VII | 15 | |
| Diacrylat VIII | | 15 |
| 1-Hydroxycyclohexylphenylketon | 5 | 5 |
| η (35°C) [mPas] | 4990 | 5110 |
| *E-Modul [N/mm²] | 14.9 | 12.3 |
| *σₘₐₓ [N/mm²] | 2.7 | 4.8 |
| *ε [%] | 39.6 | 60.2 |
| **E-Modul [N/mm²] | 70.4 | 124.8 |
| **σₘₐₓ [N/mm²] | 10.9 | 12.5 |
| **ε [%] | 43.5 | 41.8 |
| Weiterreisswiderstand [N/mm] | 9.8 | 10.6 |
| Shore D-Härte | | |

| | | |
|---|---|---|
| * Werte nach Laserhärtung (40 mJ/cm²) | | |
| ** Werte nach vollständiger Aushärtung | | |

## Patentansprüche

1. Photoempfindliches flüssiges Gemisch, enthaltend
(1) 40 bis 80 Gew.-% eines Urethan(meth)acrylates mit einer Funktionalität von 2 bis 4 und einem Molekulargewicht (MG) von 500 bis 10000,
(2) 5 bis 40 Gew.-% eines hydroxygruppenhaltigen aliphatischen oder cycloaliphatischen Di(meth)acrylates,
(3) 0 bis 40 Gew.-% eines Mono(meth)acrylates oder einer Mono-N-vinylverbindung mit einem MG von höchstens 500,
(4) 0,1 bis 10 Gew.-% eines Photoinitiators,
(5) 0 bis 30 Gew.-% eines von (2) verschiedenen aliphatischen oder cycloaliphatischen Di(meth)acrylates, eines aliphatischen Tri(meth)acrylates oder eines aromatischen Dioder Tri(meth)acrylates und
(6) 0 bis 5 Gew.-% üblicher Additive, wobei der Anteil der Komponenten (1) bis (6) zusammen 100 Gew.-% beträgt.

2. Gemisch gemäss Anspruch 1, enthaltend
40 bis 80 Gew.-% eines Urethan(meth)acrylates mit einer Funktionalität von 2 bis 4 und einem Molekulargewicht (MG) von 500 bis 10000,
(2) 5 bis 40 Gew.-% eines hydroxygruppenhaltigen aliphatischen oder cycloaliphatischen Di(meth)acrylates,
(3) 5 bis 40 Gew.-% eines Mono(meth)acrylates oder einer Mono-N-vinylverbindung mit einem MG von höchstens 500,
(4) 0,1 bis 10 Gew.-% eines Photoinitiators,
(5) 0 bis 30 Gew.-% eines von (2) verschiedenen aliphatischen oder cycloaliphatischen Di(meth)acrylates, eines aliphatischen Tri(meth)acrylates oder eines aromatischen Dioder Tri(meth)acrylates und
(6) 0 bis 5 Gew.-% üblicher Additive.

3. Gemisch gemäss Anspruch 1, enthaltend als Komponente (1) ein aliphatisches Urethanacrylat.

4. Gemisch gemäss Anspruch 1, enthaltend als hydroxygruppenhaltiges aliphatisches Diacrylat (2) ein Umsetzungsprodukt aus Butan- 1,4-dioldiglycidylether und Acrylsäure.

5. Gemisch gemäss Anspruch 1, enthaltend als Komponente (2) ein hydroxygruppenhaltiges cycloaliphatisches Di(meth)acrylat.

6. Gemisch gemäss Anspruch 5, enthaltend als Komponente (2) ein Umsetzungsprodukt aus Hexahydrophthalsäurediglycidylester oder Bis-(3,4-epoxycyclohexylmethyl)-adipat und (Meth)acrylsäure.

7. Gemisch gemäss Anspruch 1, enthaltend als Komponente (3) eine Mono-N-vinylverbindung.

8. Gemisch gemäss Anspruch 7, enthaltend als Komponente (3) N-Vinylpyrrolidon.

9. Gemisch gemäss Anspruch 1, enthaltend als Photoinitiator (4) ein 1-Hydroxyphenylketon.

10. Gemisch gemäss Anspruch 9, enthaltend als Photoinitiator 1-Hydroxycyclohexylphenylketon.

11. Gemisch gemäss Anspruch 1, enthaltend als Komponente (5) ein Umsetzungsprodukt aus einem Bisphenoldiglycidylether und Acrylsäure.

12. Gemisch gemäss Anspruch 11, enthaltend als Komponente (5) ein Umsetzungsprodukt aus einem Bisphenol A-diglycidylether und Acrylsäure.

13. Verfahren zum Polymerisieren der Gemische gemäss Anspruch 1, indem man diese mit aktinischem Licht bestrahlt.

14. Verfahren zur Herstellung von dreidimensionalen Gegenständen aus den flüssigen, erfindungsgemässen Gemischen mittels lithographischen Verfahren, wobei die Oberfläche einer Schicht aus dem erfindungsgemässen, flüssigen Gemisch ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht aus den erfindungsgemässen Gemischen auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

15. Verfahren gemäss Anspruch 14, indem als Strahlenquelle ein Laserstrahl, vorzugsweise ein computergesteuerter Laserstrahl, verwendet wird.

16. Verwendung eines Gemisches gemäss Anspruch 1 zur Herstellung von photopolymerisierten Schichten, insbesondere in Form von dreidimensionalen Gegenständen, die aus mehreren aneinander haftenden, verfestigten Schichten aufgebaut sind.

## Claims

1. A photosensitive liquid mixture comprising
(1) 40 to 80% by weight of a urethane (meth)acrylate having a functionality of 2 to 4 and a molecular weight (MW) of 500 to 10,000,
(2) 5 to 40% by weight of a hydroxyl-containing aliphatic or cycloaliphatic di(meth)acrylate,
(3) 0 to 40% by weight of a mono(meth)acrylate or of a mono-N-vinyl compound having a MW of not more than 500,
(4) 0.1 to 10% by weight of a photoinitiator,
(5) 0 to 30% by weight of an aliphatic or cycloaliphatic di(meth)acrylate which differs from (2), of an aliphatic tri(meth)acrylate or of an aromatic di- or tri(meth)acrylate, and
(6) 0 to 5% by weight of customary additives,
such that the proportion of components (1) to (6) together is 100% by weight.

2. A mixture according to claim 1, comprising
(1) 40 to 80% by weight of a urethane (meth)acrylate having a functionality of 2 to 4 and a molecular weight (MW) of 500 to 10,000,
(2) 5 to 40% by weight of a hydroxyl-containing aliphatic or cycloaliphatic di(meth)acrylate,
(3) 5 to 40% by weight of a mono(meth)acrylate or of a mono-N-vinyl compound having a MW of not more than 500,
(4) 0.1 to 10% by weight of a photoinitiator,
(5) 0 to 30% by weight of an aliphatic or cycloaliphatic di(meth)acrylate which differs from (2), of an aliphatic tri(meth)acrylate or of an aromatic di- or tri(meth)acrylate, and
(6) 0 to 5% by weight of customary additives.

3. A mixture according to claim 1, comprising as component (1) an aliphatic urethane acrylate.

4. A mixture according to claim 1, comprising as hydroxyl-containing diacrylate (2) a reaction product of 1,4-butanediol diglycidyl ether and acrylic acid.

5. A mixture according to claim 1, comprising as component (2) a hydroxyl-containing cycloaliphatic di(meth)acrylate.

6. A mixture according to claim 5, comprising as component (2) a reaction product of the diglycidyl ester of hexahydrophthalic acid or bis(3,4-epoxycyclohexylmethyl) adipate and (meth) acrylic acid.

7. A mixture according to claim 1, comprising as component (3) a mono-N-vinyl compound.

8. A mixture according to claim 7, comprising as component (3) N-vinylpyrrolidone.

9. A mixture according to claim 1, comprising as photoinitiator (4) a 1-hydroxyphenyl ketone.

10. A mixture according to claim 1, comprising as photoinitiator (4) a 1-hydroxycyclohexyl phenyl ketone.

11. A mixture according to claim 1, comprising as component (5) a reaction product of bisphenol diglycidyl ether and acrylic acid.

12. A mixture according to claim 11, comprising as component (5) a reaction product of a bisphenol A diglycidyl ether and acrylic acid.

13. A process for polymerizing a mixture according to claim 1 by irradiating it with actinic light.

14. A process for the production of three-dimensional objects from the novel liquid mixtures by lithographic methods, wherein a layer of novel liquid mixture is irradiated over the entire surface or in a predetermined pattern with a UV/VIS light source, such that within the irradiated areas a layer solidifies in a desired layer thickness, then a new layer of novel mixture is formed on the solidified layer, which is likewise irradiated over the entire surface or in a predetermined pattern, and such that three-dimensional objects comprising a plurality of solidified layers which adhere to one another are obtained by repeated coating and irradiation.

15. A process according to claim 14, wherein a laser beam, preferably a computer-controlled laser beam, is used as radiation source.

16. Use of a mixture according to claim 1 for the production of photopolymerized layers, especially in the form of three-dimensional objects which are composed of a plurality of solidified layers which adhere to one another.

## Revendications

1. Mélange liquide photosensible, contenant :
(1) de 40 à 80 % en poids de uréthanne-(méth)acrylate de 40 à 80, avec une fonctionnalité de 2 à 4 et un poids moléculaire de 500 à 10 000,
(2) de 5 à 40 % en poids d'un di(méth)acrylate aliphatique ou cycloaliphatique contenant des groupes hydroxy,
(3) de 0 à 40 % en poids d'un mono(méth)acrylate ou d'un composé mono-N-vinylique avec un poids moléculaire au maximum 500,
(4) de 0,1 à 10 % en poids d'un photoamorceur,
(5) de 0 à 30 % en poids d'un di(méth)acrylate aliphatique ou cycloaliphatique différent du (2), d'un tri(méth)acrylate aliphatique ou d'un di- ou tri(méth)acrylate aromatique, et
(6) de 0 à 5 % en poids d'additifs usuels,
la teneur en composants (1) à (6) ensemble représente 100 % en poids.

2. Mélange selon la revendication 1, contenant :
(1) de 40 à 80 % en poids d'un uréthanne-(méth)acrylate avec une fonctionnalité de 2 à 4 et un poids moléculaire de 500 à 10 000,
(2) de 5 à 40 % en poids d'un di(méth)acrylate aliphatique ou cycloaliphatique contenant des groupes hydroxy,
(3) de 5 à 40 % en poids d'un mono(méth)acrylate ou d'un composé mono-N-vinylique avec un poids moléculaire au maximum 500,
(4) de 0,1 à 10 % en poids d'un photoamorceur,
(5) de 0 à 30 % en poids d'un di(méth)acrylate aliphatique ou cycloaliphatique différent du (2), d'un tri(méth)acrylate aliphatique ou d'un di- ou tri(méth)acrylate aromatique, et
(6) de 0 à 5 % en poids d'additifs usuels.

3. Mélange selon la revendication 1, contenant comme composant (1) un uréthanne-acrylate aliphatique.

4. Mélange selon la revendication 1, contenant un diacrylate aliphatique contenant des groupes hydroxy (2), de l'éther diglycidylique du butane-1,4-diol et de l'acide acrylique.

5. Mélange selon la revendication 1, contenant comme composant (2) un di(méth)acrylate cycloaliphatique contenant des groupes hydroxy.

6. Mélange selon la revendication 5, contenant comme composant (2) un un produit de réaction de l'hexahydrophtalate de diglycidyle ou de l'adipate de bis-(3,4-époxycyclohexylméthyle) et de l'acide (méth)acrylique.

7. Mélange selon la revendication 1, contenant comme composant (3) un composé de mono-N-vinylique.

8. Mélange selon la revendication 7, contenant comme composant (3) la N-vinylpyrrolidone.

9. Mélange selon la revendication 1, contenant comme photoamorceur (4) une 1-hydroxyphénylcétone.

10. Mélange selon la revendication 9, contenant comme photoamorceur une 1-hydroxycyclohexylphénylcétone.

11. Mélange selon la revendication 1, contenant comme composant (5) un produit de réaction d'un éther diglycidylique de bisphénol et de l'acide acrylique.

12. Mélange selon la revendication 11, contenant comme composant (5) un produit de réaction d'un éther diglycidylique du bisphénol A et de l'acide acrylique.

13. Procédé de polymérisation du mélange selon la revendication 1, dans lequel on irradie celui-ci par une lumière actinique.

14. Procédé de préparation d'objets à trois dimensions à partir des mélanges liquides conformes à l'invention, à l'aide de procédés lithographiques, en irradiant la surface d'une couche à partir du mélange liquide conforme à l'invention sur la totalité de la surface ou selon un modèle prédéterminé, par une source de lumière UV/VIS, de façon telle qu'une couche se consolide dans une épaisseur de couche voulue aux endroits irradiés, puis on forme sur la couche consolidée une nouvelle couche à partir des mélanges conformes à l'invention, que l'on irradie également sur la totalité de la surface ou selon un modèle prédéterminé et on obtient alors, par revêtement et irradiation répétés, des objets tridimensionnels constitués de plusieurs couches adhérentes les unes sur les autres.

15. Procédé selon la revendication 14, dans lequel on utilise comme source de rayonnement un rayon laser, de préférence un rayon laser piloté par ordinateur.

16. Utilisation d'un mélange selon la revendication 1 pour la préparation de couches photopolymérisées, en particulier sous forme d'objets à trois dimensions, qui sont constitués de plusieurs couches consolidées, adhérentes les unes aux autres.
